# EUROPÄISCHE PATENTSCHRIFT

(11) **EP 0 666 595 B1**
(45) Veröffentlichungstag und Bekanntmachung des Hinweises auf die Patenterteilung: **19.08.1998**
(21) Anmeldenummer: 95100373.0
(22) Anmeldetag: 12.01.1995
(51) Int. Cl.: H01L 25/065, H01L 23/498

(54) **Verfahren zur Herstellung einer kubisch integrierten Schaltungsanordnung**
Method of manufacture of a cubic integrated circuit structure
Procédé pour la fabrication d'un dispositif d'un circuit intégré cubique

(30) Priorität: 07.02.1994 DE 4403736
(43) Veröffentlichungstag der Anmeldung: 09.08.1995
(73) Patentinhaber: SIEMENS AKTIENGESELLSCHAFT, 80333 München (DE)
(72) Erfinder: Hönlein, Wolfgang, Dr., D-82008 Unterhaching (DE); Schwarzl, Siegfried, Dr., D-85579 Neubiberg (DE)

(56) Entgegenhaltungen:
- EP-A- 0 213 774
- US-A- 5 262 226
- 1990 SYMPOSIUM ON VLSI TECHNOLOGY, 4.Juni 1990 - 7.Juni 1990 HONOLULU,USA, Seiten 95-96, HAYASHI ET AL 'Fabrication of three-dimensional IC using cumulatively bonded IC (CUBIC) technology'
- 1993 PROCEEDINGS. 43RD ELECTRONIC COMPONENTS AND TECHNOLOGY CONFERENCE , 1.Juni 1993 - 4.Juni 1993 ORLANDO,FL,USA, Seiten 1081-1084, FUJITA Y ET AL 'Feasibility study on through-wafer interconnecting method for hybrid wafer-scale-integration'

## Beschreibung

Bei der kubischen Integration werden mehrere Substrate übereinander gestapelt und fest miteinander verbunden. Die einzelnen Substrate umfassen dabei jeweils integrierte Schaltungen, Sensor-Aktuator-Anordnungen und/oder planare passive Bauelemente. Die einzelnen Substrate können dabei in unterschiedlichen Technologien hergestellt sein. Untereinander sind die in den verschiedenen Substraten enthaltenen Bauelemente durch vertikale Kontakte miteinander elektrisch verbunden.

Bei der Herstellung einer solchen kubisch integrierten Schaltungsanordnung werden zunächst die Substrate unabhängig voneinander hergestellt. Dann werden die unabhängig voneinander hergestellten Substrate extrem gedünnt, bis herab zu etwa 10 µm. Die gedünnten Substrate werden auf der Vorder- und der Rückseite mit elektrischen Kontakten versehen und so übereinander angeordnet, daß neben den elektrischen Anforderungen der Schaltungsanordnung auch mechanische und thermische Anforderungen erfüllt werden. Die Schaltungsanordnung muß mechanisch stabil sein, wobei extreme mechanische Spannungen vermieden werden sollen. Ferner muß die Verlustwärme, die mit steigender Integration zunimmt, abgeführt werden.

Aus Y. Hayashi et al, Symp. on VLSI Technol. (1990) Seite 95 ff. ist bekannt, bei der kubischen Integration die prozessierte Vorderseite eines Substrats beim Dünnen und den weiteren Prozeßschritten dadurch zu schützen, daß eine massive Trägerschicht aus zum Beispiel Silizium oder Quarz auf die Vorderseite des Substrats aufgeklebt wird. Von der Rückseite wird das Substrat dann gedünnt und mit Kontakten versehen. Anschließend wird das gedünnte Substrat auf ein weiteres Substrat aufgebracht und in einem Bondprozeß fest mit diesem verbunden. Nach dem Bondprozeß müssen die Trägerschichten wieder abgelöst werden, ohne daß die Bauelemente in den Substraten beschädigt werden oder die Verbindung zwischen den Substraten wieder gelöst wird. Ein Testen der Bauelemente in dem gedünnten Substrat ist vor dem Bondprozeß nur von der Rückseite her möglich, da die Trägerschicht die Vorderseite bedeckt und da gedünnte Substrate ohne stabilisierende Trägerschicht übliche Testprozeduren nicht überstehen. Beidseitiges Kontaktieren ist jedoch beim Testen von nicht autarken IC's, wie zum Beispiel für die inneren Ebenen eines Speicher-Stacks, erforderlich.

Poröse Aluminiumoxyd-Trägerplatten sind auch aus US-A-5 262 226 bekannt.

Zur Herstellung von Kontakten und Metallisierungsstrukturen auf der Rückseite der gedünnten Substrate sind zahlreiche Prozeßschritte erforderlich.

Der Erfindung liegt das Problem zugrunde, ein Verfahren zur Herstellung einer kubisch integrierten Schaltungsanordnung anzugeben, bei dem ein Testen von gedünnten Substraten von beiden Seiten her möglich ist.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren wird als Trägerplatte eine dotierte monokristalline Siliziumscheibe verwendet, in der zuvor durch elektrochemisches Ätzen in einem fluoridhaltigen, sauren Elektrolyten, in dem die Siliziumscheibe als Anode verschaltet ist, durchgehende Poren erzeugt werden. Die Poren weisen Durchmesser im Bereich 1 bis 10 µm auf. Derartig poröses Silizium wird allgemein als makroporös bezeichnet. Mindestens ein Teil der Poren wird auf ihrer Oberfläche mit einer isolierenden Schicht versehen und mit leitfähigen Füllungen aufgefüllt.

Vorzugsweise wird die gesamte Oberfläche der Siliziumscheibe mit einer isolierenden Schicht zum Beispiel durch thermische Oxidation versehen. Die Trägerplatte wird auf einer ersten Hauptfläche eines Substrates, das mindestens im Bereich der ersten Hauptfläche Bauelemente umfaßt und das gemeinsam mit anderen Substraten in der kubisch integrierten Schaltungsanordnung integriert wird, befestigt. Auf der ersten Hauptfläche des Substrats sind Kontakte zu den Bauelementen angeordnet. Mindestens auf der an die erste Hauptfläche des Substrats angrenzenden Oberfläche der Trägerplatte werden Anschlußflächen gebildet, die jeweils mit mindestens einer leitfähigen Füllung elektrisch verbunden sind. Diese Anschlußflächen treffen jeweils auf mindestens einen Kontakt auf der ersten Hauptfläche des Substrats. Aufeinander treffende Anschlußflächen und Kontakte werden fest miteinander verbunden und stellen die feste Verbindung zwischen der Trägerplatte und dem Substrat dar.

Die leitfähigen Füllungen werden vorzugsweise aus dotiertem Polysilizium, Aluminium, Kupfer oder Amalgam-Komponenten erzeugt. Die Kontakte werden vorzugsweise aus Wolfram, Au/In oder Amalgam-Komponenten erzeugt. Die Verbindung zwischen den Anschlußflächen und den Kontakten erfolgt vorzugsweise durch Löten, oder Amalgamisierung .

Die Trägerplatte aus makroporösem Silizium weist eine hohe mechanische Stabilität auf, so daß sie das Substrat während der Dünnung und der Weiterprozessierung stabilisiert. Über die leitfähigen Füllungen in den Poren der Trägerplatte ist auch nach dem Dünnen ein Testen der Bauelemente im Substrat von beiden Seiten her möglich. Gegebenenfalls werden dazu zusätzlich auf der dem Substrat abgewandten Oberfläche der Trägerplatte Anschlußflächen gebildet.

Die Trägerplatte aus makroporösem Silizium weist eine ausreichende mechanische Stabilität auch noch bei einer Dicke von 100 bis 200 µm auf.

Es liegt im Rahmen der Erfindung, die Trägerplatte als Verbindungselement zwischen benachbarten Substraten einer kubisch integrierten Schaltungsanordnung zu verwenden. Dazu wird die Trägerplatte auf gegenüberliegenden Seiten mit entsprechenden Anschlußflächen versehen. Die vertikale Kontaktierung der verschiedenen Substrate der kubisch integrierten Schaltungsanordnung erfolgt über die leitfähigen Füllungen der Trägerplatte. Zur Einstellung von Widerstand und Kapazität derartiger Verbindungen ist einerseits die Auswahl des Materials für die leitfähigen Füllungen und andererseits eine Parallelverschaltung mehrerer Poren geeignet.

Da die Trägerplatten im wesentlichen symmetrisch aufgebaut sind, werden thermische Verbiegungen weitgehend vermieden.

Es liegt im Rahmen der Erfindung, die Trägerplatten so anzuordnen, daß sie zum Abtransport von Verlustleistung geeignet sind. Dazu werden die Trägerplatten insbesondere so angeordnet, daß sie teilweise über benachbarte Substrate seitlich hinausragen und mit Kühlvorrichtungen thermisch in Verbindung stehen.

Seitlich überstehende Teile von Trägerplatten können zusätzlich mit Anschlußkontakten versehen sein, die über eine Metallisierungsebene mit Bauelementen in mindestens einem der Substrate verbunden sind. Über derartige Anschlußkontakte lassen sich zum Beispiel Versorgungsspannungen anlegen oder Testmessungen durchführen.

Im weiteren wird die Erfindung anhand der Figuren und der Ausführungsbeispiele weiter erläutert.
- Figur 1: zeigt die Ansicht einer Trägerplatte.
- Figur 2: zeigt einen Schnitt durch die Trägerplatte.
- Figur 3: zeigt den Aufbau einer kubisch integrierten Schaltungsanordnung mit zwei Substraten.
- Figur 4: zeigt einen Schnitt durch eine kubisch integrierte Schaltungsanordnung.

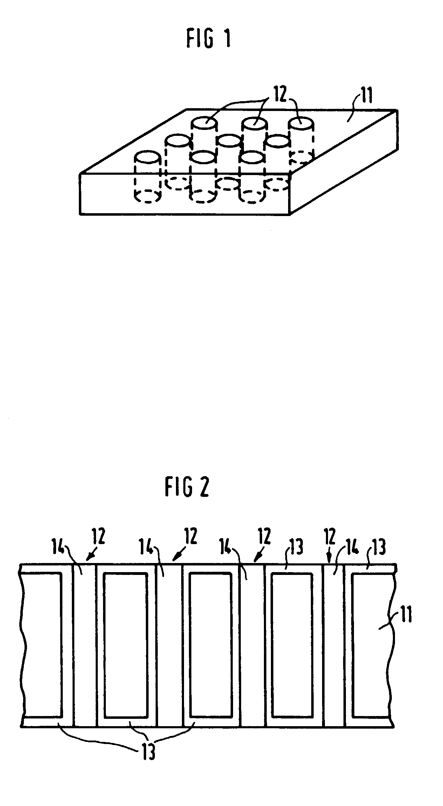

In einer Siliziumscheibe 11 aus n-dotiertem, monokristallinem Silizium mit <100>-Orientierung werden durch elektrochemisches Ätzen Poren 12 erzeugt (siehe Figur 1). Dazu wird die Siliziumscheibe 1 mit einer Oberfläche mit einem fluoridhaltigen, sauren Elektrolyten in Kontakt gebracht. Der Elektrolyt enthält eine Flußsäurekonzentration von 1 bis 50 Prozent, vorzugsweise 6 Prozent. Dem Elektrolyten kann ein Netzmittel (Tensid) zugesetzt werden, um die Entwicklung von Wasserstoffbläschen auf der Oberfläche der Siliziumscheibe 11 zu unterdrücken. Zwischen die Siliziumscheibe 11 und den Elektrolyten wird eine Spannung von zum Beispiel 3 Volt angelegt. Dabei wird die Siliziumscheibe 11, die zum Beispiel einen spezifischen Widerstand von 5 Ohm x cm aufweist, als Anode verschaltet. Von der Rückseite her wird die Siliziumscheibe 11 beleuchtet. Durch die Beleuchtung wird in der Siliziumscheibe 11 eine Stromdichte von etwa 10 mA pro cm² eingestellt.

Bei der elektrochemischen Ätzung bewegen sich Minoritätsladungsträger in dem Silizium zu der mit dem Elektrolyten in Kontakt stehenden Oberfläche. An dieser Oberfläche bildet sich eine Raumladungszone aus. Da die Feldstärke im Bereich von Vertiefungen, die mit statistischer Verteilung in jeder Oberfläche vorhanden sind oder gezielt durch eine Phototechnik und eine alkalische Ätze erzeugt werden, größer ist als außerhalb davon, bewegen sich die Minoritätsladungsträger bevorzugt zu diesen Punkten. Dadurch kommt es zu einer Strukturierung der Oberfläche. Je tiefer eine anfänglich kleine Unebenheit durch die Ätzung wird, desto mehr Minoritätsladungsträger bewegen sich dorthin und desto stärker ist der Ätzangriff an dieser Stelle. Auf diese Weise wachsen Poren in <100>-Richtung bis in eine Tiefe, die unter anderem durch die Ätzzeit vorgegeben ist.

In dem erfindungsgemäßen Verfahren durchqueren die Poren 12 die gesamte Siliziumscheibe 11. Bei einer Dicke der Siliziumscheibe 11 von 100 µm, ist dazu eine Ätzzeit von etwa 2 Stunden erforderlich. Der Durchmesser der Poren wird dabei auf einen Wert zwischen 1 µm und 10 µm eingestellt.

Die durchgehenden Poren 12 in der Siliziumscheibe 11 werden, gegen die Siliziumscheibe 11 durch eine isolierende Schicht 13 isoliert, mit leitfähigen Füllungen 14 versehen (siehe Figur 2). Die isolierende Schicht 13 wird vorzugsweise durch thermische Oxidation über die gesamte Oberfläche der Siliziumscheibe 11 gebildet.

Die leitfähigen Füllungen 14 werden zum Beispiel aus dotiertem Polysilizium, Aluminium, Kupfer oder aus Amalgam-Komponenten erzeugt. Unter Amalgam-Komponenten werden Materialien verstanden, von denen eine Komponente fest ist und die andere Komponente flüssig, wobei sich die feste Komponente in der flüssigen Komponente löst, was zu einem Aushärten des Gemisches führt. Die leitfähigen Füllungen 14 werden in die Poren 12 vorzugsweise auf folgende Weise eingebracht:
a) durch konforme ganzflächige Abscheidung zum Beispiel durch CVD mit anschließender planarisierender Rückätzung, zum Beispiel durch Plasmaätzen oder chemical-mechanical polishing (CMP) oder
b) durch selektive Abscheidung (CVD, electroless Plating) auf einem Hilfssubstrat.

Die Siliziumscheibe 11 mit den durchgehenden Poren 12, die, gegen die Siliziumscheibe 11 isoliert mit den leitfähigen Füllungen 14 versehen sind, wird bei der Herstellung einer kubisch integrierten Schaltungsanordnung als Trägerplatte verwendet.

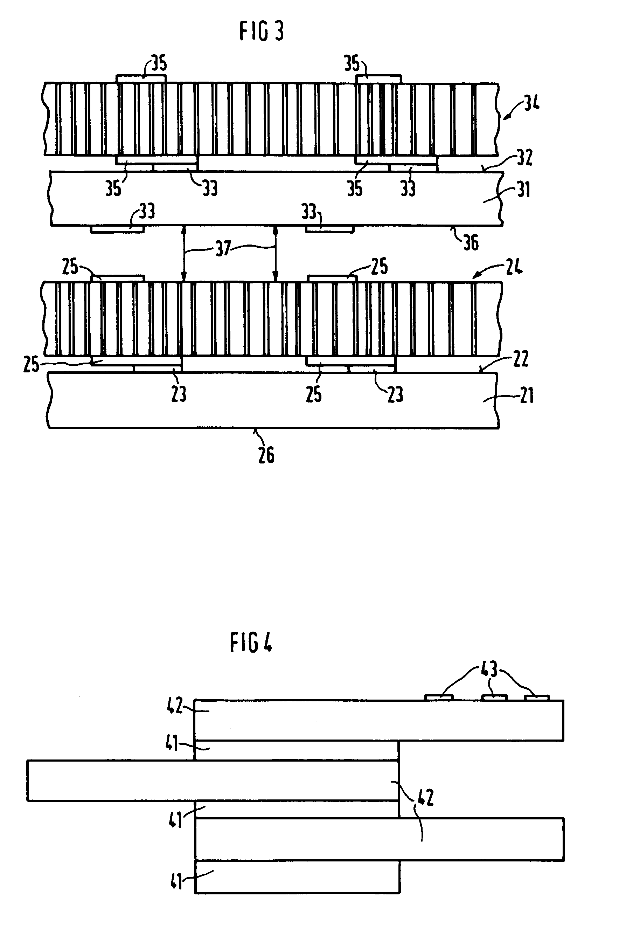

Zur Herstellung einer kubisch integrierten Schaltungsanordnung wird von einem ersten Substrat 21 ausgegangen, das eine erste Hauptfläche 22 aufweist (siehe Figur 3). Im Bereich der ersten Hauptfläche 22 umfaßt das erste Substrat 21 Bauelemente. Auf der ersten Hauptfläche 22 sind Kontakte 23 zu den Bauelementen, die der Übersichtlichkeit halber nicht im einzelnen dargestellt sind, angeordnet. Eine erste Trägerplatte 24, die aus einer makroporösen Siliziumscheibe mit durchgehenden Poren, die, gegen die Siliziumscheibe isoliert, mit leitfähigen Füllungen versehen sind, aufgebaut ist, wird auf das erste Substrat 21 aufgebracht. Zuvor werden mindestens auf der an die erste Hauptfläche 22 angrenzenden Oberfläche der Trägerplatte 24 Anschlußflächen 25 erzeugt, die jeweils mit mindestens einer leitfähigen Füllung der Trägerplatte 24 elektrisch verbunden sind. Die Anschlußflächen 25 sind darüber hinaus mit der ersten Trägerplatte 24 mechanisch fest verbunden. Die Anschlußflächen 25 bestehen zum Beispiel aus einer Metallisierung wie Wolfram, Aluminium, Amalgamkomponenten. Die Anschlußflächen 25 treffen beim Zusammenfügen der ersten Trägerplatte 24 mit dem ersten Substrat 21 auf Kontakte 23 auf der ersten Hauptfläche 22. Es wird eine feste Verbindung zwischen den jeweils zusammentreffenden Kontakten 23 und Anschlußflächen 24 hergestellt. Dieses erfolgt zum Beispiel durch Löten oder Amalgamisieren. Über diese feste Verbindung ist die erste Trägerplatte 24 mit dem ersten Substrat 21 fest verbunden.

Über die leitfähigen Füllungen in der ersten Trägerplatte 24, die über die Anschlußflächen 25 und die Kontakte 23 mit den jeweiligen Bauelementen in dem ersten Substrat 21 verbunden sind, lassen sich diese Bauelemente testen. Zur Erleichterung der Kontaktierung werden auf der dem ersten Substrat 21 abgewandten Oberfläche der ersten Trägerplatte 24 ebenfalls Anschlußflächen 25, die mit den jeweiligen leitfähigen Füllungen in Verbindung stehen, erzeugt.

Bedingt durch die hohe mechanische Stabilität von makroporösem Silizium ist eine Dicke senkrecht zur ersten Hauptfläche 22 der ersten Trägerplatte 24 von 100 bis 200 µm ausreichend, um das erste Substrat 21 bei der weiteren Prozessierung zu stabilisieren. Die Dicke der Trägerplatte 24 wird vorzugsweise durch chemisch-mechanisches Polieren eingestellt. Zur weiteren Prozessierung gehört bei der kubischen Integration das Dünnschleifen von einer zweiten Hauptfläche 26, die der ersten Hauptfläche 22 gegenüberliegt sowie das Aufbringen von Kontakten auf die zweite Hauptfläche 26.

Ein zweites Substrat 31 umfaßt im Bereich einer ersten Hauptfläche 32 Bauelemente, zu denen auf der ersten Hauptfläche 32 Kontakte 33 angeordnet sind (siehe Figur 3). Auf das zweite Substrat wird eine zweite Trägerplatte 34 aufgebracht, die aus einer makroporösen Siliziumscheibe mit durchgehenden Poren besteht, wobei die Poren, gegen die Siliziumscheibe isoliert, mit leitfähigen Füllungen versehen sind. Auf der an die erste Hauptfläche 32 des ersten Substrats 31 angrenzenden Oberfläche der zweiten Trägerplatte 34 sind Anschlußflächen aufgebracht, die jeweils mit mindestens einer leitfähigen Füllung der zweiten Trägerplatte 35 elektrisch verbunden sind. Die Anschlußflächen 35 treffen beim Zusammenfügen jeweils auf einen Kontakt 33 auf der ersten Hauptfläche 32 des zweiten Substrats 31. Zur besseren Kontaktierbarkeit der leitfähigen Füllung in der zweiten Trägerplatte 34 werden auf der dem zweiten Substrat 31 abgewandten Oberfläche der zweiten Trägerplatte 34 ebenfalls Anschlußflächen zu den entsprechenden leitfähigen Füllungen aufgebracht.

Das zweite Substrat 31 wird von einer zweiten Hauptfläche 36, die der ersten Hauptfläche 32 gegenüberliegt, hier vorzugsweise durch läppen, naßchemisches Spin-Ätzen oder chemisch mechanisches Polieren gedünnt. Anschließend werden auf die zweite Hauptfläche 36 Kontakte 33 aufgebracht.

Zur Integration des ersten Substrats 21 und des zweiten Substrats 31 in einer kubisch integrierten Schaltungsanordnung wird das zweite Substrat 31 auf die dem ersten Substrat 21 abgewandte Oberfläche der ersten Trägerplatte 24 aufgebracht. Diese Bewegung ist in Figur 3 durch die Doppelpfeile 37 angedeutet. Dabei treffen die Kontakte 33 auf der zweiten Hauptfläche des zweiten Substrats 31 auf Anschlußflächen 25 der Trägerplatte 24. Durch Löten oder Amalgamisierung werden die Kontakte 33 fest mit den Anschlußflächen 25 verbunden. Diese feste Verbindung stellt gleichzeitig die Verbindung zwischen dem zweiten Substrat 31 und der ersten Trägerplatte 24 dar. Auf diese Weise werden das erste Substrat 21 und das zweite Substrat 31 sowohl mechanisch als auch elektrisch über die erste Trägerplatte 24 miteinander verbunden. Zur Verstärkung der mechanischen Festigkeit können Dummy-Kontakte 33 und Dummy-Anschlußflächen 25 aufgebracht werden, die von den Bauelementen auf den Substraten 21, 31 elektrisch isoliert sind, und/oder Klebeverbindungen verwendet werden.

Zum Aufbau komplexerer kubisch integrierter Schaltungsanordnungen werden auf die zweite Trägerplatte in analoger Weise, das heißt mit weiteren Trägerplatten, weitere Substrate aufgebracht und fest verbunden.

Figur 4 zeigt eine kubisch integrierte Schaltungsanordnung, in der drei Substrate 41 nach dem erfindungsgemäßen Verfahren über Trägerplatten 42 miteinander verbunden sind. Die Trägerplatten 42 sind wie anhand von Figur 1 und 2 geschildert aufgebaut. Die Trägerplatten 42 überragen die Substrate 41 seitlich. Auf diese Weise wird durch Verlustleistung erzeugte Wärme seitlich abgeführt. In dem seitlich überstehenden Teil der Trägerplatten 42 sind darüber hinaus Anschlußkontakte 43 aufgebracht, über die zum Beispiel Versorgungsspannungen angelegt und Testmessungen durchgeführt werden können.

## Patentansprüche

1. Verfahren zur Herstellung einer kubisch integrierten Schaltungsanordnung,
- bei dem in einer dotierten monokristallinen Siliziumscheibe (11) durch elektrochemisches Ätzen in einem fluoridhaltigen, sauren Elektrolyten, in dem die Siliziumscheibe (11) als Anode verschaltet ist, durchgehende Poren (12) erzeugt werden,
- bei dem mindestens ein Teil der Poren, gegen die Siliziumscheibe (11) isoliert, mit leitfähigen Füllungen (14) versehen werden,
- bei dem die Siliziumscheibe (11) als Trägerplatte (24) auf einer ersten Hauptfläche (22) eines Substrates (21), das mindestens im Bereich der ersten Hauptfläche (22) Bauelemente umfaßt, das auf der ersten Hauptfläche (22) Kontakte (23) zu den Bauelementen aufweist und das gemeinsam mit anderen Substraten (31) in der kubisch integrierten Schaltungsanordnung integriert wird, befestigt wird,
- bei dem mindestens auf der an die erste Hauptfläche (22) angrenzenden Oberfläche der Trägerplatte (24) Anschlußflächen (25), die mit mindestens einer leitfähigen Füllung (14) elektrisch verbunden sind und die auf mindestens einen Kontakt (23) auf der ersten Hauptfläche (22) treffen, gebildet werden, die mit den jeweiligen Kontakten (23) fest verbunden werden.

2. Verfahren nach Anspruch 1,
bei dem die Siliziumscheibe (11) durch chemisch-mechanisches Polieren gedünnt wird.

3. Verfahren nach Anspruch 1 oder 2,
bei dem die Trägerplatte (24) eine Dicke zwischen 100 µm und 300 µm und Poren (12) Durchmesser zwischen 1 µm und 10 µm aufweisen.

4. Verfahren nach einem der Ansprüche 1 bis 3,
- bei dem nach der Herstellung der Poren (12) die gesamte Oberfläche der Siliziumscheibe (11) mit isolierendem Material (13) versehen wird und
- bei dem die leitfähigen Füllungen (14) aus dotiertem Polysilizium, Aluminium, Kupfer oder aus Amalgam-Komponenten erzeugt werden.

5. Verfahren nach einem der Ansprüche 1 bis 4,
- bei dem das Substrat (21) von einer zweiten Hauptfläche (26), die der ersten Hauptfläche (22) gegenüberliegt, her gedünnt wird,
- bei dem auf der zweiten Hauptfläche (26) des Substrats (21) Kontakte erzeugt werden, die mit Bauelementen im Bereich der ersten Hauptfläche (22) des Substrats (21) elektrisch verbunden sind.

6. Verfahren nach einem der Ansprüche 1 bis 5,
- bei dem eine weitere Trägerplatte (34), die im wesentlichen wie die erst genannte Trägerplatte (24) mit leitfähigen Füllungen versehenen Poren versehen ist, auf einer ersten Hauptfläche (32) eines weiteren Substrats (31), das im Bereich der ersten Hauptfläche (32) Bauelemente umfaßt und das auf der ersten Hauptfläche (32) Kontakte (33) zu den Bauelementen aufweist, befestigt wird,
- bei dem mindestens auf der an die erste Hauptfläche (32) des weiteren Substrats (31) angrenzenden Oberfläche der weiteren Trägerplatte (34) Anschlußflächen (35) gebildet werden, die mit mindestens einer leitfähigen Füllung elektrisch verbunden sind, die jeweils auf mindestens einen Kontakt (33) auf der ersten Hauptfläche (32) treffen und die mit denjenigen Kontakten (33) fest verbunden werden,
- bei dem das weitere Substrat (31) von einer zweiten Hauptfläche (36), die der ersten Hauptfläche (32) gegenüberliegt, her gedünnt wird,
- bei dem auf der zweiten Hauptfläche (36) des weiteren Substrats (31) Kontakte (33) erzeugt werden, die mit Bauelementen im Bereich der zweiten Hauptfläche (36) des weiteren Substrats (31) elektrisch verbunden sind,
- bei dem auf der zweiten Hauptfläche (36) des weiteren Substrats (31) die erstgenannte Trägerplatte (24) so befestigt wird, daß das erstgenannte Substrat (21) und das weitere Substrat (31) an gegenüberliegenden Seiten der erstgenannten Trägerplatte (24) angeordnet sind,
- bei dem auf der an die zweite Hauptfläche (36) des weiteren Substrats (31) angrenzenden Oberfläche der erstgenannten Trägerplatte (24) Anschlußflächen (25) gebildet werden, die mit mindestens einer leitfähigen Füllung elektrisch verbunden sind, die jeweils auf mindestens einen Kontakt (33) auf der zweiten Hauptfläche (36) des weiteren Substrats (31) treffen und die mit den jeweiligen Kontakten (33) fest verbunden werden.

7. Verfahren nach Anspruch 6,
bei dem mindestens einige der Anschlußflächen (25) mindestens einer der Trägerplatten (24) so strukturiert werden, daß sie mit leitfähigen Füllungen benachbarter Poren elektrisch verbunden sind, so daß diese parallel geschaltet sind.

8. Verfahren nach Anspruch 6 oder 7,
bei dem mindestens eine der Trägerplatten (42) mindestens eines der benachbarten Substrate (41) seitlich überragt.

9. Verfahren nach Anspruch 8,
bei dem die seitlich überragende Trägerplatte (42) in dem seitlich überragenden Teil mindestens einen Anschlußkontakt (43) aufweist, der über eine Metallisierungsebene mit Bauelementen in mindestens einem der Substrate (41) verbunden ist.

## Claims

1. Method for the production of a cubically integrated circuit arrangement,
- in which through-pores (12) are produced in a doped monocrystalline silicon wafer (11) by electrochemical etching in a fluoride-containing acidic electrolyte in which the silicon wafer (11) is connected as the anode,
- in which at least some of the pores, while being insulated from the silicon wafer (11), are provided with conductive fillings (14),
- in which the silicon wafer (11) is fastened as a support plate (24) on a first main face (22) of a substrate (21) which comprises components at least in the region of the first main face (22), which has contacts (23) to the components on the first main face (22) and which is integrated in common with other substrates (31) in the cubically integrated circuit arrangement,
- in which, at least on that surface of the support plate (24) adjoining the first main face (22), connection faces (25) which are electrically connected to at least one conductive filling (14) and touch at least one contact (23) on the first main face (22) are formed, and are firmly connected to the respective contacts (23).

2. Method according to Claim 1, in which the silicon wafer (11) is thinned by chemical/mechanical polishing.

3. Method according to Claim 1 or 2, in which the support plate (24) has a thickness of between 100 µm and 300 µm and pores (12) have diameters of between 1 µm and 10 µm.

4. Method according to one of Claims 1 to 3,
- in which, after production of the pores (12), the entire surface of the silicon wafer (11) is provided with insulating material (13), and
- in which the conductive fillings (14) are produced from doped polysilicon, aluminium, copper or amalgam components.

5. Method according to one of Claims 1 to 4,
- in which the substrate (21) is thinned from the direction of a second main face (26) which lies opposite the first main face (22),
- in which contacts, which are electrically connected to components in the region of the first main face (22) of the substrate (21), are produced on the second main face (26) of the substrate (21).

6. Method according to one of Claims 1 to 5,
- in which a further support plate (34) which, essentially like the first-mentioned support plate (24), is provided with pores provided with conductive fillings, is fastened on a first main face (32) of a further substrate (31) which comprises components in the region of the first main face (32) and has contacts (33) to the components on the first main face (32),
- in which, at least on that surface of the further support plate (34) adjoining the first main face (32) of the further substrate (31), connection faces (35) are formed which are electrically connected to at least one conductive filling, which respectively touch at least one contact (33) on the first main face (32) and which are firmly connected to those contacts (33),
- in which the further substrate (31) is thinned from the direction of a second main face (36) which lies opposite the first main face (32),
- in which contacts (33), which are electrically connected to components in the region of the second main face (36) of the further substrate (31), are produced on the second main face (36) of the further substrate (31),
- in which the first-mentioned support plate (24) is fastened on the second main face (36) of the further substrate (31) in such a way that the first-mentioned substrate (21) and the further substrate (31) are arranged on opposite sides of the first-mentioned support plate (24),
- in which, on that surface of the first-mentioned support plate (24) adjoining the second main face (36) of the further substrate (31), connection faces (25) are formed which are electrically connected to at least one conductive filling, which respectively touch at least one contact (33) on the second main face (36) of the further substrate (31) and which are firmly connected to the respective contacts (33).

7. Method according to Claim 6, in which at least some of the connection faces (25) of at least one of the support plates (24) are structured in such a way that they are electrically connected to conductive fillings of neighbouring pores so that these are connected in parallel.

8. Method according to Claim 6 or 7, in which at least one of the support plates (42) protrudes laterally beyond at least one of the neighbouring substrates (41).

9. Method according to Claim 8, in which the laterally protruding support plate (42) has, in the laterally protruding part, at least one connection contact (43) which is connected via a metallization plane to components in at least one of the substrates (41).

## Revendications

1. Procédé de fabrication d'un dispositif d'un circuit intégré cubique
- dans lequel des pores traversants (12) sont réalisés dans une plaquette de silicium monocristallin dopé (11) par attaque électrochimique dans un électrolyte acide fluoruré, dans lequel la plaquette de silicium (11) est connectée comme anode, dans lequel au moins une partie des pores, isolés par rapport à la plaquette de silicium (11), est pourvue de remplissages conducteurs (14),
- dans lequel la plaquette de silicium (11) est fixée comme plaque porteuse (24) sur une première face principale (22) d'un substrat (21), qui comporte des composants au moins dans la zone de la première face principale (22), qui présente sur la première face principale (22) des contacts (23) avec les composants et qui est intégré avec d'autres substrats (31) dans le dispositif de circuit intégré cubique,
- dans lequel des plages de connexions (25), reliées électriquement à au moins un remplissage conducteur (14) et touchant au moins un contact (23) de la première face principale (22), sont formées au moins sur la surface de la plaque porteuse (24) adjacente à la première face principale (22) et sont reliées fixement aux contacts respectifs (23).

2. Procédé selon la revendication 1,
dans lequel la plaquette de silicium (11) est amincie par polissage chimico-mécanique.

3. Procédé selon la revendication 1 ou 2,
dans lequel la plaque porteuse (24) présente une épaisseur comprise entre 100 µm et 300 µm et les pores (12) un diamètre compris entre 1 µm et 10 µm.

4. Procédé selon l'une des revendications 1 à 3,
- dans lequel, après la fabrication des pores (12), l'ensemble de la surface de la plaquette de silicium (11) est pourvu d'un matériau isolant (13) et
- dans lequel les remplissages conducteurs (14) sont réalisés en polysilicium dopé, aluminium, cuivre ou en composants amalgamés.

5. Procédé selon l'une des revendications 1 à 4,
- dans lequel le substrat (21) est aminci à partir d'une deuxième face principale (26), opposée à la première face principale (22),
- dans lequel des contacts qui sont reliés électriquement avec des composants dans la zone de la première face principale (22) du substrat (21) sont réalisés sur la deuxième face principale (26) du substrat (21).

6. Procédé selon l'une des revendications 1 à 5,
- dans lequel une autre plaque porteuse (34) qui, pour l'essentiel, est munie de pores pourvus de remplissages conducteurs comme la première plaque porteuse citée (24), est fixée à une première face principale (32) d'un autre substrat (31) qui comporte des composants dans la zone de la première face principale (32) et présente des contacts (33) avec les composants sur la première face principale (32),
- dans lequel des plages de connexions (35), qui sont reliées électriquement à au moins un remplissage conducteur, qui touchent chaque fois au moins un contact (33) de la première face principale (32) et qui sont reliées fixement avec ces contacts (33), sont formées au moins sur la surface de l'autre plaque porteuse (34) adjacente à la première face principale (32) de l'autre substrat (31),
- dans lequel l'autre substrat (31) est aminci à partir d'une deuxième face principale (36), opposée à la première face principale (32),
- dans lequel des contacts (33), qui sont reliés électriquement à des composants dans la zone de la deuxième face principale (36) de l'autre substrat (31), sont réalisés sur la deuxième face principale (36) de l'autre substrat (31),
- dans lequel la première plaque porteuse citée (24) est fixée sur la deuxième face principale (36) de l'autre substrat (31) de sorte que le premier substrat cité (21) et l'autre substrat (31) sont disposés sur les côtés opposés de la première plaque porteuse citée (24),
- dans lequel des plages de connexions (25), qui sont reliées électriquement à au moins un remplissage conducteur, qui touchent chaque fois au moins un contact (33) de la deuxième face principale (36) de l'autre substrat (31) et qui sont reliées fixement aux contacts respectifs (33), sont formées sur la surface de la première plaque porteuse citée (24) adjacente à la deuxième face principale (36) de l'autre substrat (31).

7. Procédé selon la revendication 6,
dans lequel au moins quelques plages de connexions (25) d'au moins une des plaques porteuses (24) sont structurées de manière à être reliées électriquement à des remplissages conducteurs de pores voisins de sorte que ceux-ci sont connectés en parallèle.

8. Procédé selon la revendication 6 ou 7,
dans lequel au moins une des plaques porteuses (42) déborde latéralement d'au moins un des substrats (41) voisins.

9. Procédé selon la revendication 8,
dans lequel la plaque porteuse (42) faisant latéralement saillie présente dans la partie qui déborde latéralement un contact de connexion (43) qui, grâce à un plan de métallisation, est relié à des composants d'au moins un des substrats (41).
